# EUROPÄISCHE PATENTSCHRIFT

(11) **EP 0 953 186 B1**
(45) Veröffentlichungstag und Bekanntmachung des Hinweises auf die Patenterteilung: **06.02.2002**
(21) Anmeldenummer: 97949946.4
(22) Anmeldetag: 18.11.1997
(51) Int. Cl.: G06K 19/077

(54) **CHIPKARTENMODUL**
CHIP CARD MODULE
MODULE DE CARTE A PUCE

(30) Priorität: 15.01.1997 DE 19701165
(43) Veröffentlichungstag der Anmeldung: 03.11.1999
(73) Patentinhaber: Infineon Technologies AG, 81669 München (DE)
(72) Erfinder: HOUDEAU, Detlef, D-84085 Langquaid (DE); EMMERT, Stefan, D-93158 Teublitz (DE); MENSCH, Hans-Georg, D-92431 Neunburg (DE)
(74) Vertreter: Zedlitz, Peter, Dipl.-Inf.
(86) Internationale Anmeldenummer: DE9702701
(87) Internationale Veröffentlichungsnummer: WO9832098

(56) Entgegenhaltungen:
- EP-A- 0 197 847
- EP-A- 0 688 051
- EP-A- 0 694 871

## Beschreibung

Die Erfindung betrifft einen Chipkartenmodul, bei dem ein oder mehrere Halbleiterchips und/oder ein Versteifungsrahmen mit Hilfe eines speziellen Klebstoffs befestigt sind. Der Klebstoff zeichnet sich dadurch aus, daß ihm Partikel definierter Größe als Abstandhalter beigefügt sind.

In der EP 0 688 051 A1 ist ein Chipkartenmodul offenbart, bei welchem ein Chip auf die darunter befindlichen Leiterbahnen aufgeklebt wird. Der hierzu verwendete Klebstoff enthält Partikel definierter Größe und ist elektrisch anisotrop leitend, wodurch eine elektrische Kontaktierung zwischen paarweise gegenüberliegenden Kontaktflächen des Chips einerseits und der Leiterbahnen andererseits ermöglicht wird.

Bei Chipkartenmodulen ist es von besonderer Wichtigkeit, daß der oder die im Modul enthaltenen Halbleiterchips einerseits mit möglichst geringem Abstand auf eine Unterlage aufgeklebt werden, um eine geringe Bauhöhe des Moduls zu gewährleisten. Andererseits muß die Klebstoffschicht über die gesamte Klebefläche elektrisch isolieren und von gleichmäßiger Dicke sein, um Deformationen des Chips zu vermeiden, die zu seiner Beschädigung führen könnten. Besonders vorteilhaft wäre es, wenn die Klebeschicht sich gewissen Verformungen des Moduls anpassen und diese auffangen könnte, um so die Belastung des Halbleiterchips zu vermindern. Mit gleichmäßigem Abstand von der Unterlage befestigte Halbleiterchips erleichtern zudem den Ablauf der Folgeverarbeitungsschritte wie dem Drahtbonden und erhöhen die Zuverlässigkeit der fertigen Chipkarten.

Entsprechendes gilt für Versteifungsrahmen, die vor allem in Zusammenhang mit flexibler Trägerfolie verwendet und auf die Trägerfolie oder auf ein Leiterbahnsystem geklebt werden. In letzterem Fall muß der Versteifungsrahmen vom Leiterbahnsystem elektrisch isoliert werden, ohne daß durch die Klebstoffschicht die Bauhöhe der Chipkartenmodule zu sehr vergrößert wird.

Die bisher bekannten Lösungen weisen bezüglich der oben angesprochenen Probleme einige Nachteile auf.

**Aufgabe** der Erfindung ist es, einen Chipkartenmodul anzugeben, bei dem ein oder mehrere Halbleiterchips und/ oder ein Versteifungsrahmen in einem vorgegebenen und über die gesamte Klebefläche im wesentlichen gleichmäßigen Abstand bei möglichst geringer Dicke der Klebstoffschicht auf einer Unterlage angeklebt sind. Die Klebstoffschicht sollte zudem Verformungen des Chipkartenmoduls in gewissem Rahmen auffangen und ausgleichen können, so daß die Möglichkeit der Beschädigung von Halbleiterchips und Versteifungsrahmen verringert wird.

Die Lösung der Aufgabe gelingt mit dem Chipkartenmodul gemäß den Ansprüchen 1 und 2. Bevorzugte Ausführungsformen ergeben sich aus den Unteransprüchen.

Die Erfindung betrifft also einen Chipkartenmodul, welcher wenigstens einen Chipträger, einen oder mehrere Halbleiterchips, Leitbahnen und gegebenenfalls einen Versteifungsrahmen umfaßt. Der wenigstens eine Halbleiterchip und/oder der Versteifungsrahmen sind mit Hilfe eines elektrisch nichtleitenden Klebstoffs befestigt, dem elektrisch nichtleitende Partikel definierter Größe als Abstandhalter zugesetzt sind.

Die dem Klebstoff zugegebenen Partikel bestimmter Größe gestatten es, die Klebstoffmasse, die erfindungsgemäß ohne Klebstoffmasse aufgetragen wird, bis auf eine definierte Schichtdicke zusammenzudrücken, die im wesentlichen dem Durchmesser der Partikel entspricht. Zweckmäßig besitzen alle Partikel im wesentlichen die gleiche Größe. Bei einer gleichmäßigen Verteilung dieser Partikel im Klebstoff ist dann dafür gesorgt, daß beim Andrücken des Halbleiterchips oder des Versteifungsrahmens auf die Unterlage, an die sie geklebt werden sollen, über die gesamte Klebefläche ein gleichmäßiger Abstand zur Unterlage eingehalten wird.

Eine im wesentlichen einheitliche Größe der Partikel ist nicht Voraussetzung der Erfindung. Es ist vielmehr ausreichend, wenn neben einem Anteil Partikel geringerer Größe eine hinreichende Menge Partikel vorhanden ist, deren Größe dem gewünschten Abstand zwischen Halbleiterchip oder Versteifungsrahmen und Unterlage entspricht, und diese Partikel gleichmäßig im Klebstoff verteilt sind.

Wie bereits angedeutet, wird die Größe der Partikel entsprechend dem gewünschten Abstand zwischen dem zu befestigenden Gegenstand und der Unterlage gewählt. Die Partikel besitzen zweckmäßig Kugelform, und ihr Durchmesser entspricht der gewünschten Klebeschichtdicke. Wegen der im Klebstoff enthaltenen Partikel wird nicht nur das Befestigen der Halbleiterchips und Versteifungsrahmen in definierter Höhe sowie gleichmäßigem und geringem Abstand von der Unterlage erleichtert, sondern auch die Dosierung des Klebstoffes. Die Dosierung kann ohne Klebermaske erfolgen, und überschüssiger Klebstoff wird an den Seiten des Halbleiterchips oder Versteifungsrahmens herausgedrückt, ohne daß deshalb die Ausbildung einer unregelmäßigen Klebeverbindung zu befürchten wäre.

Eine für die Herstellung von Chipkartenmodulen geeignete Partikelgröße liegt im Bereich von 4 bis 40 um und insbesondere um etwa 20 µm Teilchendurchmesser.

Die Partikel können aus hartem und nicht verformbaren Material wie Glas oder Hartkunststoff hergestellt sein. Vorzugsweise sind die Partikel jedoch aus einem verformbaren und insbesondere einem reversibel verformbaren Material wie verformbarem Kunststoff hergestellt.

Harte Partikel im Kunststoff haben den Nachteil, daß sie sich Verformungen im Chipkartenmodul nicht anpassen können und in derartigen Fällen zu punktförmigen Druckbelastungen führen, die die verklebten Gegenflächen beschädigen können.

Bei Halbleiterchips können diese punktförmigen Druckbelastungen zu Rissen oder sogar Brüchen im Chip und damit zum Totalausfall des Chipkartenmoduls führen. Durch Verwendung verformbarer Füllstoffe können Verformungen des Chipkartenmoduls durch die Partikel aufgenommen und die punktförmigen Druckbelastungen auf die Gegenflächen abgemildert werden.

Als verformbare oder reversibel verformbare Materialien für die Füllstoffpartikel eignen sich Kunststoffmaterialien. Besonders geeignet sind Hohlkügelchen aus Kunststoff, die unter Druck verformbar sind. Die Verformbarkeit der Partikel sollte zweckmäßig nicht so groß sein, daß bereits beim Aufdrücken des anzuklebenden Halbleiterchips oder Versteifungsrahmens auf die Unterlage eine dauerhafte Verformung der Partikel eintritt und die Partikel ihrer Funktion als Abstandhalter nicht mehr genügen können.

Zum Ausgleich von Verformungen im Chipkartenmodul, die zu dessen Beschädigung führen können, ist es weiterhin vorteilhaft, als Klebstoff einen elastischen Klebstoff zu verwenden. Dieser elastische Klebstoff ist in der Lage, Verformungen des Chipkartenmoduls zu folgen und diese dadurch in gewissem Maße auszugleichen und so die Belastungen auf Halbleiterchip oder Versteifungsrahmen zu verringern.

Als elastische Klebstoffe eignen sich sogenannte "Low Stress"-Klebstoffe, die nach dem beispielsweise thermischen Aushärten flexibel bleiben. Beispielhaft können synthetische Kautschuke und insbesondere Siliconklebstoffe genannt werden.

Die Erfindung eignet sich besonders zur Anwendung in Chipkartenmodulen mit flexibler Trägerfolie, kann jedoch gleichermaßen in Chipkartenmodulen mit stabilen Anschlußrahmen, die üblicherweise aus Metall bestehen, verwendet werden. Außerdem kann die Erfindung zur Befestigung eines Versteifungsrahmens auf einem Leitbahnsystem eingesetzt werden und bietet insbesondere dann Vorteile, wenn der Versteifungsrahmen gestanzt ist und einen Stanzgrat aufweist, der in sehr geringem Abstand zum Leitbahnsystem befestigt werden soll.

Die Erfindung wird nachfolgend anhand einer Zeichnung näher erläutert. Darin zeigen:
- Fig. 1: schematisch und im Querschnitt einen erfindungsgemäßen Chipkartenmodul;
- Fig. 2: schematisch einen Querschnitt durch einen weiteren erfindungsgemäßen Chipkartenmodul;
- Fig. 3: schematisch eine Draufsicht auf einen erfindungsgemäßen Chipkartenmodul mit Versteifungsrahmen und
- Fig. 4: schematisch einen Teilquerschnitt entlang der Linie A-A in Fig. 3.

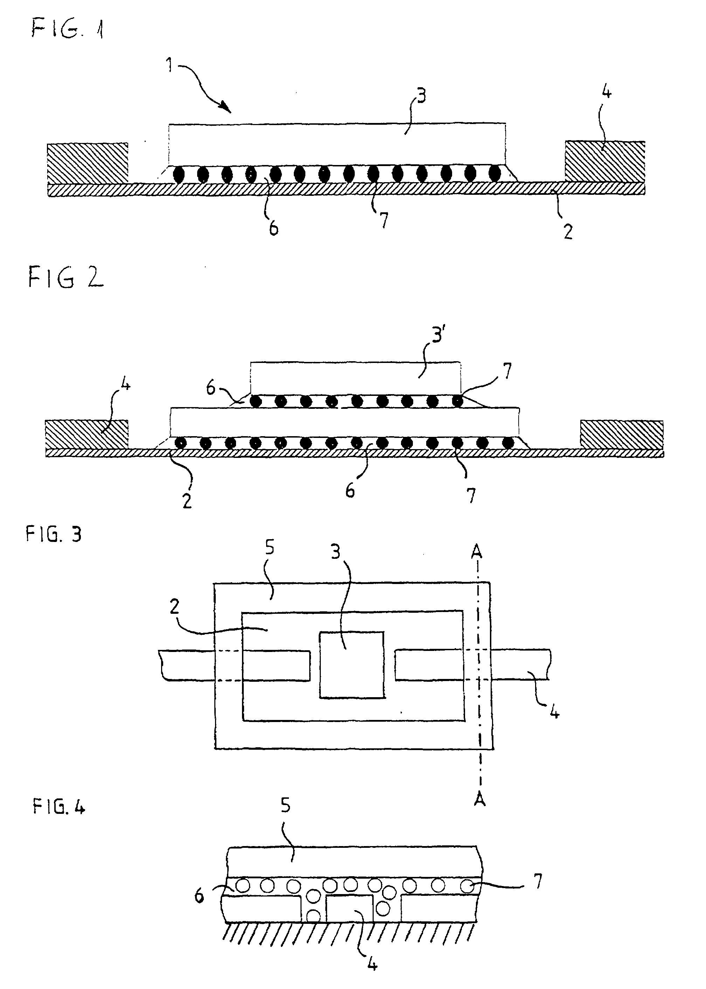

Fig. 1 zeigt im Querschnitt einen erfindungsgemäßen Chipkartenmodul 1, bei dem ein Halbleiterchip 3 auf einem Träger 2, in diesem Fall einer Kunststoff-Trägerfolie, angeordnet ist (sogenannter Chip-On-Flex-Modul). Auf dem Träger befindet sich weiterhin ein System aus Leitbahnen 4, mit dem der Halbleiterchip 3 auf übliche Weise, z.B. durch Drahtbonden, kontaktiert werden kann (nicht gezeigt). Die Befestigung des Halbleiterchips 3 auf dem Träger 2 erfolgt mit einem elektrisch nichtleitendem Klebstoff 6, dem erfindungsgemäß elektrisch nichtleitende Partikel 7 einer definierten Größe zugesetzt sind. Die Partikel bewirken einerseits, daß zwischen Chip und Träger der gewünschte Abstand eingehalten wird und andererseits der Abstand über die gesamte Auflagefläche des Chips gleichbleibend ist. Dadurch kann der Abstand zwischen Chip und Träger sehr klein gehalten werden. Zudem wird durch die definierte und exakte Lage des Halbleiterchips auf dem Träger das Herstellen der Drahtkontakte zwischen Chip und Leiterbahnen erleichtert.

Fig. 2 zeigt einen sogenannten Chip-On-Chip-Modul, dessen unterer Teil im wesentlichen dem in Fig. 1 gezeigten Modul entspricht. Auf dem ersten Chip 3 ist ein weiterer Chip 3' montiert. Auch dieser zweite Chip 3' ist mit Hilfe des mit Partikeln 7 definierter Größe gefüllten Klebstoffs 6 befestigt. Im gezeigten Fall sind die Partikel in beiden Klebstoffschichten gleich groß. Es können aber für verschiedene Klebstoffebenen sowohl unterschiedliche Klebstoffe als auch Klebstoffe mit unterschiedlich großen Partikeln gewählt werden. Um Beschädigungen der Chips durch Verformung des Chipkartenmoduls zu verhindern, wird als Klebstoff vorzugsweise ein elastischer Klebstoff in Verbindung mit verformbaren Partikeln, z.B. Kunststoff-Hohlkugeln, gewählt.

In Fig. 3 ist ein Chipkartenmodul mit einem Halbleiterchip 3 dargestellt, der, z.B. auf die vorstehend beschriebene Weise, auf einem flexiblen Trägerband 2 befestigt ist. Zu beiden Seiten des Chips verlaufen Leitbahnen 4, die mit dem Chip kontaktiert werden (nicht gezeigt). Im gezeigten Modul sind beidseitig ober- und unterhalb des Trägerbandes (montage- und kontaktseitig) Metallisierungsflächen und Leitbahnen vorhanden. Derartige Module umfassen zur_Stabilisierung üblicherweise einen Versteifungsrahmen, der in Fig. 3 mit 5 bezeichnet ist. Der Rahmen besteht in der Regel aus einem leitfähigen Material und insbesondere aus Metall. Üblicherweise wird er durch Stanzen hergestellt und weist daher häufig auf einer Seite einen Stanzgrat auf (nicht abgebildet). Um Kurzschlüsse zwischen Versteifungsrahmen 5 und den benachbarten Leitbahnen 4 zu vermeiden, muß der Abstand zwischen beiden größer sein als die Höhe des Stanzgrats. Andererseits darf die zulässige Gesamtbauhöhe für den Chipkartenmodul nicht überschritten werden. Eine genaue Einhaltung der minimalen Klebstoffdicke ist daher notwendig.

Erfindungsgemäß wird dies durch den Klebstoff 6 erreicht, dem Partikel 7 definierter Größe als Abstandhalter beigemengt sind. Fig. 4 zeigt die entsprechende Anordnung im Querschnitt entlang der Linie A-A in Fig. 3. Der Klebstoff 6 ist erneut vorzugsweise ein elastischer Klebstoff, die Partikel 7 sind bevorzugt verformbare Teilchen.

## Patentansprüche

1. Chipkartenmodul (1), welcher wenigstens einen Chipträger (2), einen oder mehrere Halbleiterchips (3, 3') und Leitbahnen (4) umfaßt, bei welchem ein oder mehrere Halbleiterchips (3, 3') mit Hilfe eines Klebstoffs (6) befestigt sind, dem Partikel (7) definierter Größe als Abstandhalter zugesetzt sind,
**dadurch gekennzeichnet,**
**daß** der Klebstoff (6) elektrisch nichtleitend ist und die dem Klebstoff (6) zugesetzten Partikel (7) aus elektrisch nichtleitendem Material bestehen.

2. Chipkartenmodul (1), welcher wenigstens einen Chipträger (2), einen oder mehrere Halbleiterchips (3, 3') und Leitbahnen (4) umfaßt,
**dadurch gekennzeichnet,**
**daß** er einen Versteifungsrahmen (5) umfaßt, welcher mit Hilfe eines elektrisch nichtleitenden Klebstoffs (6) auf den Chipträger befestigt ist, und daß dem Klebstoff (6) Partikel (7) aus elektrisch nichtleitendem Material und mit definierter Größe als Abstandhalter zugesetzt sind.

3. Chipkartenmodul gemäß Anspruch 1 oder 2,
**dadurch gekennzeichnet,**
**daß** der Klebstoff (6) ein elastischer Klebstoff, insbesondere ein synthetischer Kautschuk und vorzugsweise ein Siliconklebstoff ist.

4. Chipkartenmodul gemäß einem der Ansprüche 1 bis 3,
**dadurch gekennzeichnet,**
**daß** die Partikel (7) einen Durchmesser zwischen 4 und 40 µm und insbesondere von etwa 20 µm aufweisen.

5. Chipkartenmodul gemäß einem der Ansprüche 1 bis 4,
**dadurch gekennzeichnet,**
**daß** die Partikel (7) aus einem verformbaren Material und insbesondere aus Kunststoff bestehen.

6. Chipkartenmodul gemäß Anspruch 5,
**dadurch gekennzeichnet,**
**daß** die Partikel (7) Kunststoff-Hohlkugeln sind.

7. Chipkartenmodul gemäß einem der Ansprüche 1 bis 6,
**dadurch gekennzeichnet,**
**daß** der Chipträger (2) ein metallischer Anschlußrahmen oder eine flexible Trägerfolie ist.

8. Chipkartenmodul gemäß einem der Ansprüche 1 bis 7,
**dadurch gekennzeichnet,**
**daß** er zwei Halbleiterchips (3, 3') umfaßt, von denen einer unter Verwendung des mit Partikeln (7) versetzten Klebstoffs (6) auf den anderen Halbleiterchip geklebt ist.

9. Chipkartenmodul gemäß einem der Ansprüche 1 bis 8,
**dadurch gekennzeichnet,**
**daß** er einen Versteifungsrahmen (5) umfaßt, der unter Verwendung des mit Partikeln (7) versetzten Klebstoffs (6) auf ein Leitbahnsystem (4) geklebt ist.

10. Chipkartenmodul gemäß Anspruch 9,
**dadurch gekennzeichnet,**
**daß** der Versteifungsrahmen (5) einen Stanzgrat aufweist und der Durchmesser der Partikel (7) größer ist als die Höhe dieses Stanzgrates.

## Claims

1. Chip card module (1), which comprises at least one chip carrier (2), one or more semiconductor chips (3, 3') and conductor tracks (4), in which one or more semiconductor chips (3, 3') are attached with the aid of an adhesive (6) with which particles (7) of defined size are admixed as spacers, **characterized in that** the adhesive (6) is electrically nonconducting and the particles (7) mixed with the adhesive (6) consist of electrically nonconducting material.

2. Chip card module (1), which comprises at least one chip carrier (2), one or more semiconductor chips (3, 3') and conductor tracks (4), **characterized in that** it comprises a stiffening frame (5), which is attached on the chip carrier with the aid of electrically nonconducting adhesive (6), and **in that** particles (7) of electrically nonconducting material and of defined size are admixed with the adhesive (6) as spacers.

3. Chip card module according to Claim 1 or 2, **characterized in that** the adhesive (6) is a flexible adhesive, in particular a synthetic rubber and preferably a silicone adhesive.

4. Chip card module according to one of Claims 1 to 3, **characterized in that** the particles (7) have a diameter of between 4 and 40 µm and, in particular, of about 20 µm.

5. Chip card module according to one of Claims 1 to 4, **characterized in that** the particles (7) consist of a deformable material and, in particular, of plastic.

6. Chip card module according to Claim 5, **characterized in that** the particles (7) are hollow plastic beads.

7. Chip card module according to one of Claims 1 to 6, **characterized in that** the chip carrier (2) is a metallic lead frame or a flexible carrier film.

8. Chip card module according to one of Claims 1 to 7, **characterized in that** it comprises two semiconductor chips (3, 3), of which one is adhesively attached on the other semiconductor chip using the adhesive (6) mixed with particles (7).

9. Chip card module according to one of Claims 1 to 8, **characterized in that** it comprises a stiffening frame (5) which is adhesively attached on a system of conductor tracks (4) using the adhesive (6) mixed with particles (7).

10. Chip card module according to Claim 9, **characterized in that** the stiffening frame (5) has a burr and the diameter of the particles (7) is greater than the height of this burr.

## Revendications

1. Module (1) de carte à puce, qui comporte au moins un support (2) de puce, une ou plusieurs puces (3, 3') à semi-conducteur et des pistes (4) conductrices, dans lequel une ou plusieurs puces (3, 3') à semi-conducteur sont fixées à l'aide d'un adhésif (6) auquel sont ajoutées comme entretoises des particules (7) de dimension définie,
**caractérisé**
**en ce que** l'adhésif (6) n'est pas conducteur de l'électricité et les particules (7) ajoutées à l'adhésif (6) sont en une matière qui n'est pas conductrice de l'électricité.

2. Module (1) de carte à puce, qui comporte au moins un support (2) de puce, une ou plusieurs puces (3, 3') à semi-conducteur et des pistes (4) conductrices,
**caractérisé**
**en ce qu'**il comprend un cadre (5) de rigidification qui est fixé au support de puce à l'aide d'un adhésif (6) qui n'est pas conducteur de l'électricité et en ce qu'il est ajouté à l'adhésif (6) en tant qu'entretoises des particules (7) en une matière qui n'est pas conductrice de l'électricité et d'une dimension définie.

3. Module de carte à puce suivant la revendication 1 ou 2,
**caractérisé**
**en ce que** l'adhésif (6) est un adhésif élastique, notamment un caoutchouc synthétique et de préférence un adhésif au silicone.

4. Module de carte à puce suivant l'une des revendications 1 à 3,
**caractérisé**
**en ce que** les particules (7) ont un diamètre compris entre 4 et 40 µm et notamment de 20 µm environ.

5. Module de carte à puce suivant l'une des revendications 1 à 4,
**caractérisé**
**en ce que** les particules (7) sont en une matière déformable et notamment en matière plastique.

6. Module de carte à puce suivant la revendication 5,
**caractérisé**
**en ce que** les particules (7) sont des billes creuses en matière plastique.

7. Module de carte à puce suivant l'une des revendications 1 à 6,
**caractérisé**
**en ce que** le support (2) de puce est un cadre métallique de raccordement ou une feuille support souple.

8. Module de carte à puce suivant l'une des revendications 1 à 7,
**caractérisé**
**en ce qu'**il comprend deux puces (3, 3') à semi-conducteur dont l'une est collée sur l'autre en utilisant l'adhésif (6) mélangé à des particules (7).

9. Module de carte à puce suivant l'une des revendications 1 à 8,
**caractérisé**
**en ce qu'**il comprend un cadre (5) de rigidification qui est collé à un système (4) de pistes conductrices en utilisant l'adhésif (6) mélangé aux particules (7).

10. Module de carte à puce suivant la revendications 9,
**caractérisé**
**en ce que** le cadre (5) de rigidification comporte une bavure d'estampage et le diamètre des particules (7) est plus grand que la hauteur de cette bavure d'estampage.
